# EUROPÄISCHE PATENTSCHRIFT

(11) **EP 1 588 375 B1**
(45) Veröffentlichungstag und Bekanntmachung des Hinweises auf die Patenterteilung: **04.08.2010**
(21) Anmeldenummer: 04701938.5
(22) Anmeldetag: 14.01.2004
(51) Int. Cl.: G11C 13/02

(54) **ORGANISCHES SPEICHERBAUELEMENT**
ORGANIC STORAGE COMPONENT
COMPOSANT DE MEMOIRE ORGANIQUE

(30) Priorität: 29.01.2003 DE 10303445
(43) Veröffentlichungstag der Anmeldung: 26.10.2005
(73) Patentinhaber: PolyIC GmbH & Co. KG, 90763 Fürth (DE)
(72) Erfinder: CLEMENS, Wolfgang, 90617 Puschendorf (DE); FIX, Walter, 90427 Nürnberg (DE); GERLT, Axel, 90766 Fürth (DE); ULLMANN, Andreas, 90765 Fürth (DE)
(74) Vertreter: Zinsinger, Norbert
(86) Internationale Anmeldenummer: PCT/EP2004/000221
(87) Internationale Veröffentlichungsnummer: WO 2004/068534

(56) Entgegenhaltungen:
- WO-A-02/43071
- WO-A-03/046922
- WO-A2-02/15264
- US-A1- 2002 195 644
- US-A1- 2004 002 176
- PATENT ABSTRACTS OF JAPAN Bd. 0181, Nr. 88 (E-1532), 31. März 1994 (1994-03-31) & JP 5 347422 A (FUJITSU LTD), 27. Dezember 1993 (1993-12-27)
- VELU G ET AL: "LOW DRIVING VOLTAGES AND MEMORY EFFECT IN ORGANIC THIN-FILM TRANSISTORS WITH A FERROELECTRIC GATE INSULATOR" APPLIED PHYSICS LETTERS, AMERICAN INSTITUTE OF PHYSICS. NEW YORK, US, Bd. 79, Nr. 5, 30. Juli 2001 (2001-07-30), Seiten 659-661, XP001086870 ISSN: 0003-6951
- KATZ HOWARD E ET AL: "Organic field-effect transistors with polarizable gate insulators" JOURNAL OF APPLIED PHYSICS, AMERICAN INSTITUTE OF PHYSICS. NEW YORK, US, vol. 91, no. 3, 1 February 2002 (2002-02-01), pages 1572-1576, XP012055675 ISSN: 0021-8979

## Beschreibung

Die Erfindung betrifft ein organisches Speicherbauelement.

Bekannt sind, beispielsweise aus der DE 10045192.6, Speicherelemente auf organischer Basis.

Für viele Anwendungen, die auf organischer Elektronik basieren, werden organische, einmal- oder wiederbeschreibbare Speicher benötigt (z.B. bei RFID-Tags oder bei einfachen elektronischen Spielen). Vor allem nichtflüchtige Speicher sind unabdingbar für z.B. elektronische Barcodes oder Wasserzeichen.

Es sind passive organische Speicherelemente bekannt, die auf ferroelektrischem Material basieren (Electronic Design, August 20,2001, Seite 56) (in diesem Artikel wird u.a. "polymeric ferroelectric RAM" vorgestellt). Zwar handelt es sich dabei um Speicher-Matrix-Aufbauten, die nicht flüchtig sind, jedoch auch um solche, die durch externe Schaltungen, vorzugsweise konventionelle Siliziumschaltungen, angesteuert werden.

Aus der Druckschrift US 2002/195644 und der dazugehörigen Veröffentlichung Howard E. Katz et al: "Organic field-effect transistors with polarizable gate insulators" in Applied Physics letter, N.Y. US, Bd. 91, Nr. 3,1. Februar 2002, Seiten 1572-1576 ist ein Speicherelement mit einem bottom-gate aufgebauten organischen Feldeffekttransistor bekannt. Dabei schließt die Gate Elektrode direkt an das Substrat an oder ist sogar in das Substrat integriert. In dem dort gezeigten OFET können Ladungen über die Polarisierung einer Schicht gespeichert werden. Die Speicherung findet in so genannten "traps" durch trap-filling statt. Nachteilig an der Anordnung ist, dass die Ladungen sich an den jeweiligen Grenzflächen akkumulieren, also durch die angrenzenden Schichten nicht abfließen können. Deshalb hängt die dort gezeigte Speicherfunktion entscheidend von dem Widerstand ab, der für den Abfluss der Ladungen, also den Übergang in die angrenzenden Schichten, existiert. Insofern ist die an die Speicherschicht angrenzende Schicht und somit auch die Schichtabfolge in dem dort gezeigten OFET für die Speicherfunktion essentiell und der Widerstand beim Übergang in diese Schicht muss für die Speicherfunktion berücksichtigt werden.

Aus der WO 2002/15264 ist ein organischer Feldeffekt Transistor mit Top-Gate Aufbau bekannt. Dort wird jedoch kein Hinweis auf eine mögliche Speicherfunktion des Bauelements gegeben.

Aufgabe der vorliegenden Erfindung ist es daher, ein nicht flüchtiges Speicherelement auf organischer Basis zu schaffen, das ohne externe Schaltung auslesbar ist und reversibel beschrieben werden kann.

Gegenstand der vorliegenden Erfindung ist ein nicht-flüchtiges Speicherelement mit einem organischen Feld-Effekt-Transistor, der folgenden Schichtaufbau umfasst:
auf einem Substrat (1) sind Source und Drain Elektroden (2) in einer halbleitenden Schicht (3) eingebettet, auf dieser Schicht (3) liegt eine Isolatorschicht (4), auf der wiederum eine Gateelektrodenschicht (6) liegt,
**dadurch gekennzeichnet, dass** der Schichtaufbau zumindest eine bistabil einstellbare organische Funktionsschicht (4,5) aus Polyvinylidendichlorid oder Polyvinylidendifluorid umfasst, bei der die Dieelektrizitätszahl bistabil einstellbar ist.

Ein organischer Speicher umfasst zumindest folgende Funktionsschichten: Untere Elektrode(n), Isolator, gegebenenfalls mit integriertem Speichermaterial, obere Elektrode.

Nach einer Ausführungsform der Erfindung wird das Speicherelement einfach durch Erhöhung der Spannung an der oberen Elektrode beschrieben.

Nach einer Ausführungsform ist das Speicherelement in einem organischen Feld-Effekt-Transistor (OFET) integriert.

Nach einer Ausführungsform dient ein Kondensatoraufbau als Speicher.

Für den Speicher wird ein Material benötigt, bei dem sich eine bestimmte Eigenschaft (z.B. el. Leitfähigkeit, Dielektrizitätszahl oder magnetische Permeabilität) durch äußere Einflüsse bistabil ändern lässt, das heißt mindestens 2 Zustände können aktiv eingestellt werden und diese Zustände bleiben zeitlich stabil. Außerdem gehört zu dem organischen Speicherelement ein weiteres Bauelement, durch das der Zustand des bistabilen Materials abgelesen und verändert werden kann. Dabei ist es bevorzugt, dass das Auslesen den Zustand des bistabilen Materials nicht verändert.

Im Folgenden wird die Erfindung noch anhand dreier Figuren, die Ausführungsformen der Erfindung zeigen, näher beschrieben.
- Figur 1: zeigt einen Speicher, der in einem OFET integriert ist.
- Figur 2: zeigt einen Kondensator als Speicher.

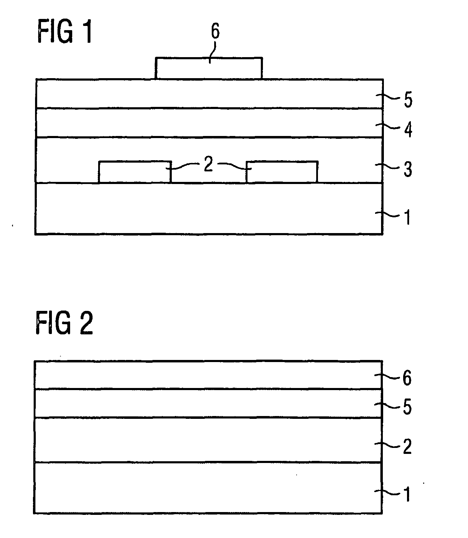

In Figur 1 ist ein OFET schematisch im Querschnitt wiedergegeben, zu erkennen ist das Substrat 1, beispielsweise eine Polyesterfolie auf dem die Source/Drain Elektroden 2 strukturiert aufgebracht sind. Dies kann beispielsweise durch Drucken oder mittels Fotolithographie geschehen. Die unteren Elektroden 2 (Source/Drain) sind in der halbleitenden Schicht 3 eingebettet, auf die die Isolatorschicht 4 folgt. Diese Schichten können wiederum durch Drucken, Rakeln, Aufschleudern oder Sprühen aufgebracht werden. Nachdem einige der Materialien, deren physikalische Eigenschaften wie Dielektrizitätszahl, elektrische Leitfähigkeit, und/oder magnetische Permeabilität sich bistabil verändern lassen auch isolierende Eigenschaften haben, kann der Speicher mit der Isolatorschicht 4 identisch sein. Dann entfällt die Schicht 5 beim OFET-Aufbau und die Gate Elektrode befindet sich direkt im Anschluss an die Isolatorschicht 4. Andererseits kann aber auch eine zusätzliche, gegebenenfalls sehr dünne Schicht 5 vorhanden sein, die aus dem bistabil einstellbaren Material ist und die sich unterhalb oder oberhalb der Isolatorschicht 4 befindet. Schließlich ist, entweder auf der Isolatorschicht aus bistabil einstellbarem Material 4 oder auf der an sie anschließenden Schicht 5, die obere Gate Elektrode 6. Der Zustand der bistabil einstellbaren Schicht 5 kann durch Anlegen einer Spannung an den Source/Drain Elektroden abgelesen werden. Durch Anlegen einer Spannung an die Gate Elektrode 6 wird der Zustand in die Schicht 5 einprogrammiert.

Figur 2 zeigt, wie ein Kondensatoraufbau als Speicher eingesetzt werden kann: Auf der unteren Elektrode 2 befindet sich die Dielektrikumsschicht 5 mit variabler Dielektrizitätszahl, auf dieser Schicht die obere Elektrode 6. Das Material mit der einstellbaren Dielektrizitätszahl der Schicht 5 liegt demnach zwischen zwei leitfähigen Schichten, der unteren Elektrode 2 und der oberen Elektrode 6 auf einem Substrat 1. Durch hohe Spannungen lässt sich die Dielektrizitätszahl einstellen. Anschließend kann der Speicherzustand durch den Ladestrom des Kondensators bestimmt werden, der ja nach Dielektrizitätszahl hoch oder niedrig ist.

Als Material mit einstellbarere Dielektrizitätskonstante kann beispielsweise Polyvinylidendichlorid (PVDC) oder Polyvinylidendifluorid (PVDF) eingesetzt werden. Bei diesen Materialien ändert sich durch hohe elektrische Felder die Dielektrizitätskonstante.

Hauptvorteil der vorliegend beschriebenen organischen Speicherelemente ist, dass sie einfach integriert werden können in organische oder polymerelektronische Schaltungen, weil sie sich durch den einfachen Aufbau leicht in die Herstellungsprozesse einfügen lassen. Die Herstellungsprozesse lassen sich leicht kombinieren. Ein weiterer Vorteil liegt in der einfachen Ansteuerung der Speicherbauelemente, wobei ein weiterer entscheidender Vorteil der ist, dass die Speicherelemente nicht flüchtig sind.

## Patentansprüche

1. Nicht-flüchtiges Speicherelement mit einem organischen Feld-Effekt-Transistor, der folgenden Schichtaufbau umfasst:
auf einem Substrat (1) sind Source und Drain Elektroden (2) in einer halbleitenden Schicht (3) eingebettet, auf dieser Schicht (3) liegt eine Isolatorschicht (4), auf der wiederum eine Gateelektrodenschicht (6) liegt,
**dadurch gekennzeichnet, dass**
der Schichtaufbau zumindest eine bistabil einstellbare organische Funktionsschicht (4,5) aus Polyvinylidendichlorid oder Polyvinylidendifluorid umfasst, bei der die Dieelektrizitätszahl bistabil einstellbar ist.

2. Speicherelement nach Anspruch 1, wobei die bistabil einstellbare Funktionsschicht die Isolatorschicht (4) ist.

3. Speicherelement nach einem der vorstehenden Ansprüche 1 oder 2, wobei die Dielektrizitätszahl der bistabil einstellbaren Funktionsschicht (4,5) durch Anlegen eines elektrischen Potentials einstellbar ist.

## Claims

1. Non-volatile memory element having an organic field-effect transistor comprising the following layer construction:
on a substrate (1), source and drain electrodes (2) are embedded in a semiconducting layer (3), and situated on said layer (3) is an insulator layer (4), on which, in turn, a gate electrode layer (6) is situated,
**characterized in that**
the layer construction comprises at least one bistably adjustable organic functional layer (4, 5) composed of polyvinylidene dichloride or polyvinylidene difluoride, in the case of which the dielectric constant is bistably adjustable.

2. Memory element according to Claim 1, wherein the bistably adjustable functional layer is the insulator layer (4).

3. Memory element according to either of the preceding Claims 1 and 2, wherein the dielectric constant of the bistably adjustable functional layer (4, 5) is adjustable by the application of an electrical potential.

## Revendications

1. Elément de mémoire non volatile avec un transistor à effet de champ organique, lequel présente la structure en couches suivante :
sur un substrat (1), des électrodes de source et de drain (2) sont noyées dans une couche semiconductrice (3), sur cette couche (3) se trouve une couche isolante (4) sur laquelle se trouve par ailleurs une couche d'électrodes de grille (6),
**caractérisé en ce que**
la structure en couches comprend au moins une couche de fonction organique réglable de manière bistable (4, 5) en polyvinylidène dichloride ou polyvinylidène difluoride, pour laquelle la constante diélectrique peut être réglée de manière à être bistable.

2. Elément de mémoire selon la revendication 1, la couche de fonction réglable de manière bistable étant la couche isolante (4).

3. Elément de mémoire selon l'une quelconque des revendications 1 ou 2, la constante diélectrique de la couche de fonction réglable de manière bistable (4, 5) pouvant être réglée en appliquant un potentiel électrique.
